# EUROPEAN PATENT SPECIFICATION

(11) **EP 3 352 421 B1**
(45) Date of publication and mention of the grant of the patent: **25.08.2021**
(21) Application number: 18152781.3
(22) Date of filing: 22.01.2018
(51) Int. Cl.: H04L 12/28, G06F 3/0484, G05B 15/02

(54) **DEVICE LOCATION MANAGEMENT FOR AUTOMATED ELECTRICAL INSTALLATION**
VORRICHTUNGSSTANDORTVERWALTUNG FÜR AUTOMATISIERTE ELEKTROINSTALLATION
DISPOSITIF DE LOCALISATION DE DISPOSITIFS POUR INSTALLATION ÉLECTRIQUE AUTOMATISÉE

(30) Priority: 24.01.2017 BE 201705040
(43) Date of publication of application: 25.07.2018
(73) Proprietor: Niko NV, 9100 Sint-Niklaas (BE)
(72) Inventor: VELDEMAN, Pol, 9140 Temse (BE); VAN OVERLOOP, Isabelle, 9032 Wondelgem (BE); ZWANCKAERT, Stijn, 9770 Kruishoutem (BE)
(74) Representative: DenK iP bv

(56) References cited:
- US-A1- 2016 047 663
- US-A1- 2016 065 413
- US-A1- 2016 210 377
- US-B1- 9 398 413
- US-B1- 9 521 009

## Description

### Field of the invention

The invention relates to the field of automated electrical installations for buildings. More specifically it relates to a processing unit for controlling a programmable electrical system of a building, a programmable electrical system comprising such processing unit, a method for configuring a programmable electrical system in a building and a related computer program product.

### Background of the invention

It is known in the art to use software-controlled automation systems in buildings. In such programmable electrical systems, addressable elements may communicate with a processing unit, e.g. a control device, via a wired bus connection or wireless data link. The addressable elements may comprise building automation equipment items, e.g. home automation equipment items. For example, such equipment items may comprise lighting, heating and/or air conditioning, natural or forced ventilation, intruder alarms, and/or actuators for closing or locking doors or shutters, maneuvering moving panels or projection screens, and similar driven products.

While such addressable elements may need to be grouped in a control software executing on the processing unit by type of element in order to perform simultaneous commands or to transmit information to a particular type of equipment, these elements may also, alternatively or additionally, need to be grouped differently by the software for other purposes, e.g. to provide a comprehensible and structured overview of the electrical system. Particularly, such grouping may be advantageously based on a location of the addressable elements in the building, e.g. to address all addressable elements in a living room, or to address a particular type of equipment, e.g. shutters, on a ground floor of the building.

The representation, e.g. in a user interface and in the underlying data topology related to such user interface, of the addressable elements, their location and the control commands associated therewith may be challenging for a user in terms of ergonomics and comprehension. Furthermore, it may be desirable that a control or configuration software of the electrical system can be used by both professional users, e.g. installers or technicians, and by casual users, e.g. the end-user, the inhabitant and/or the proprietor of the building.

While means and methods are known in the art to group addressable elements in a building automation system in a representation provided by a software running on a processing unit controlling the system, a need remains for allowing a user to assign such elements simply, intuitively and/or understandably to locations, e.g. rooms, of the building, e.g. such that such locations that can be easily identified and mentally correlated to the building topology at first glance.

For example, the European patent application EP 2 196 879 discloses a method and a control device that makes it possible to facilitate, and make more intuitive, the use of a device for controlling several home automation elements.

The disclosed method relates to a method of operating a home automation system that comprises at least one home automation equipment item of a building and a device for controlling this home automation equipment item. For example, on a control screen associated with a control device, a portion of the screen may be assigned to the display of a first graphic representation, associated with the equipment item. The method involves setting a parameter value of the home automation equipment item, involved in a definition of a scenario. The parameter value of the equipment item is implemented by action on a specific equipment control unit to modify a state of the equipment item and by action on a control device to modify appearance of a graphic representation, e.g. equipment icon, of the equipment item. An action on the specific control means may cause a phase for modification of the state of the home automation equipment item and an action on the control device may cause a phase for modification of the appearance of the first graphic representation of the home automation equipment item.

US 2016/0065413 discloses systems and methods comprising a gateway device which integrates with a premise network. A location and a status for each of a plurality of premise devices present in the premise network are visually indicated on a floor plan, for instance in the form of icons. Said floor plan is displayed on a display element of a sensor user interface coupled to the gateway device. The sensor user interface is presented to the user on a remote device. The floor plan can be edited by user input to the sensor user interface.

The European patent application EP 2 482 152 discloses a method for preparing or completing an installation of a home automation system in a building or the like. This method comprises providing on a display to a user an input screen with input functionalities for virtually entering a number of rooms of the building and for virtually adding to each room on the one hand devices and on the other hand operating means thereof. The method also comprises providing on a display to the user a linking functionality for creating a virtual link between one or more added operating means and one or more added input devices.

US 9521009 discloses an automatically configured building management system and related method. A plurality of intercommunicating control devices are positioned relative to one another on a mesh graph by a control processor, using wireless mesh network data comprising received wireless signal strength recorded by the plurality of control devices. A plurality of controlled lighting devices are positioned relatively to the control devices based on the mesh graph and on the light intensity readings recorded by each of the plurality of control device in response to a sequence of lighting devices respectively being turned on and off. The control processer iteratively creates a virtual floor plan comprising information on the relative positioning of the control devices with respect to each other and with respect to the plurality of controlled lighting devices. The virtual floor plan is also comprising room-by room groupings of control devices and controlled lighting devices.

A disadvantage of this method is that it relies on wireless interfaces for both the controlled devices and controlling devices and that the control devices have to be equipped with light sensors. Furthermore, the distribution and number of control devices have an influence on the quality of the estimated floor plan, which may comprise estimated room locations which do not coincide with or are not easily correlated to physically existing rooms in the building. As a result of the method, the user has control on the controlled devices on a room-by room basis, but cannot manually adjust or modify the automatically generated floor mapping in a straightforward and user-friendly manner.

Document US 9398413 B1 (SCALISE ET AL) 19 July 2016 discloses a computing device which is used to acquire data and information with respect to electronic devices in an area of interest. Locations of the electronic devices may be determined by location resources or by user input. A user interface is presented by the computing device. Maps may be generated, including graphical representations of the electronic devices as well as architectural features, for visualizing their respective functions and for improving cooperative operations therebetween.

### Summary of the invention

It is an object of embodiments of the present invention to provide good and efficient methods and means for allowing a user to configure and manage the locations of addressable elements of a programmable electrical system in a building.

It is an advantage of embodiments of the present invention that addressable elements in a building automation system can be grouped in a user representation that allows the assignment of such elements to locations and the management of the locations and the elements associated therewith in a simple, intuitive and/or understandable manner.

It is an advantage of embodiments of the present invention that complex relations between addressable elements, e.g. devices, actions defined on such elements and locations in a building associated therewith can be easily identified and comprehended by a user.

It is an advantage of embodiments of the present invention that repeated user interactions for the management of locations and/or the assignment of devices to locations can be avoided. For example, a prior art approach could require separate interactions for representing a location graphically on a floor plan, for creating a reference to the location in a list of locations, and for assigning devices to a location in this list, e.g. for creating actions that define the behavior of at least one output device based on at least one linked input, where this action, its output(s) and its input(s) could logically be assigned to a particular defined location.

It is an advantage of embodiments of the present invention that locations defined on a graphical map, e.g. a floor plan, can be moved, e.g. repositioned, on that graphical map while keeping graphical representations on that graphical map of devices and/or actions assigned to that location aligned with the representation of the location. For example, a prior art approach could require each graphical representation corresponding to a device and/or action linked to that location to be repositioned separately on the graphical map.

It is an advantage of embodiments of the present invention that inconsistencies arising from duplicate representations of related location concepts, e.g. a visual representation of a location on a graphical map and a textual reference to that location in a list, e.g. a perceptualized list representative of a container, list, set or tree data structure, may be avoided or reduced.

It is a further advantage of embodiments of the present invention that error tracking can be accelerated and/or that the need for such error tracking can be reduced or avoided, due to a good internal consistency of data representation and user interface representation. For example, in a prior art approach, an action may be assigned to a first location, e.g. based on a selection in a list, for example, to the exemplary location "kitchen," while this action is visually represented on a graphical map in a region that is indicated, or at least perceived by correspondence between a drawn floor plan and a building structure, as a second location, for example as the exemplary location "living room." Such situation could lead to a misplacement of the action in an interface, e.g. a control interface, that is rendered based on the assigned location, e.g. based on the selection of the location in a list, while visual confirmation of the configuration of the system based on the graphical map would not detect any apparent problem.

The above objective is accomplished by a method and device according to the present invention.

In a first aspect, the present invention relates to a processing unit for controlling a programmable electrical system of a building, in which the programmable electrical system comprises a plurality of addressable elements. The processing unit comprises an interaction interface for enabling a user, i.e. receiving an input from the user, to interact with a graphical user interface, in which the interaction interface is adapted for rendering a graphical map in the graphical user interface, on which graphical map the addressable elements are represented. The interaction interface is furthermore adapted for graphically representing, in a single view, a plurality of locations in the building by corresponding non-intersecting closed contours on the graphical map. The interaction interface is adapted for enabling the user, i.e. receiving an input from the user, to add, remove and move a closed contour representative of a location in the building on the graphical map using the graphical user interface. The interaction interface is adapted for assigning a location to an addressable element. This assignment depends on whether a graphical representation of said addressable element is contained within the closed contour graphically representing said location on said graphical map.

The processing unit furthermore comprises a storage memory for storing at least one data container comprising a definition of a location, of a closed contour associated with the location and of addressable elements assigned to the location. Each data container of the at least one data container is an independently accessible and referenceable data object that relates to, e.g. that comprises or consists of definitions of, (only) a single corresponding location and data associated with the location, e.g. that stores the data associated with only a single corresponding location.

In a processing unit in accordance with embodiments of the present invention, the interaction interface may be adapted for cutting, copying and/or saving data relating to, and data associated with, a location of the plurality of locations graphically represented on the graphical map in the at least one data container.

In a processing unit in accordance with embodiments of the present invention, the interaction interface may be adapted for pasting and/or loading data relating to, and data associated with, a location to be graphically represented on the graphical map from the at least one data container.

In a processing unit in accordance with embodiments of the present invention, the interaction interface may be adapted for assigning a location to an addressable element if the graphical or textual representation of the addressable element is contained within the corresponding closed contour.

In a processing unit in accordance with embodiments of the present invention, the interaction interface may be adapted for enabling the user, i.e. receiving an input from the user, to configure a behavior pattern that links addressable elements into coordinated actions, in which the behavior pattern may be represented on the graphical map.

In a processing unit in accordance with embodiments of the present invention, the interaction interface may be adapted for assigning a location to a behavior pattern if the representation of the behavior pattern on the graphical map is contained within the closed contour corresponding to the location.

In a processing unit in accordance with embodiments of the present invention, the data container may furthermore comprise a definition of behavior patterns between addressable elements assigned to the location.

In a processing unit in accordance with embodiments of the present invention, the control interface may be adapted for rendering a control user interface in a location-sensitive manner to enable the user, i.e. adapted for receiving an input from the user, to control the addressable elements, in which actions that are available to the user in this control interface may be grouped by the location as assigned by the interaction interface.

In a processing unit in accordance with embodiments of the present invention, the interaction interface may be adapted for enabling the user, i.e. receiving an input from the user, to move the representation of an addressable element in the graphical map.

In a processing unit in accordance with embodiments of the present invention, the interaction interface may be adapted for jointly selecting a plurality of representations of addressable elements and for jointly moving the plurality of representations.

In a processing unit in accordance with embodiments of the present invention, the interaction interface may be adapted for assigning a location to at least one addressable element in response to a user action for moving the representation of the at least one addressable element from a region outside a closed contour to a region inside the closed contour or vice versa.

In a processing unit in accordance with embodiments of the present invention, the interaction interface may be adapted for, when a new closed contour is created, assigning all addressable elements being represented in the area circumscribed by the newly created closed contour to the new location corresponding to the newly created closed contour.

In a processing unit in accordance with embodiments of the present invention, the interaction interface may be adapted for enabling the user, i.e. receiving an input from the user, to add a new closed contour in the form of a polygon, and correspondingly a new location, by drawing, line segment by line segment, that polygon.

In a processing unit in accordance with embodiments of the present invention, the interaction interface may be adapted for enabling the user, i.e. receiving an input from the user, to add a new closed contour in the form of a rectangular box, and correspondingly a new location, by drawing a diagonal of the rectangular box.

In a processing unit in accordance with embodiments of the present invention, the interaction interface may be adapted for assigning an identifier text string and/or a graphical representation to a location.

In a processing unit in accordance with embodiments of the present invention, the interaction interface may be adapted for displaying the identifier text string and/or the graphical representation of the location as a label on the graphical map.

In a processing unit in accordance with embodiments of the present invention, the interaction interface may be adapted for enabling the user, i.e. receiving an input from the user, to move the label corresponding to a location relative to the closed contour associated with the location on the graphical map.

In a processing unit in accordance with embodiments of the present invention, the interaction interface may be adapted for enabling the user, i.e. receiving an input from the user, to remove a closed contour and the location associated therewith.

In a processing unit in accordance with embodiments of the present invention, the interaction interface may be adapted for enabling the user, i.e. receiving an input from the user, to move a closed contour on the graphical map, in which any graphical and/or textual representation of an addressable element assigned to the location that corresponds to the closed contour may be moved along with that closed contour.

In a processing unit in accordance with embodiments of the present invention, the interaction interface may be adapted for enabling the user, i.e. receiving an input from the user, to add a corner to a closed contour by subdividing a line segment of a closed contour into two line segments.

In a processing unit in accordance with embodiments of the present invention, the interaction interface may be adapted for enabling the user, i.e. receiving an input from the user, to drag a corner or a line segment of a closed contour to a new position on the graphical map.

In a processing unit in accordance with embodiments of the present invention, the interaction interface may be adapted for enabling the user, i.e. receiving an input from the user, to remove at least one corner and/or at least one line segment from a closed contour.

In a processing unit in accordance with embodiments of the present invention, the interaction interface may be adapted for removing at least one corner and/or at least one line segment from a closed contour when a user action for moving a corner creates an intersection point between two line segments of the closed contour.

In a processing unit in accordance with embodiments of the present invention, the interaction interface may be adapted for enabling the user, i.e. receiving an input from the user, to resize and/or reshape a closed contour and for keeping the representations of addressable elements stationary on the graphical map while resizing and/or reshaping the closed contour.

In a processing unit in accordance with embodiments of the present invention, the interaction interface may be adapted for removing an addressable element from a location and for assigning an addressable element to a location in response to a user action for reshaping and/or resizing a closed contour representative of the location.

In a processing unit in accordance with embodiments of the present invention, the interaction interface may be adapted for detecting a collision between two closed contours such as to prevent an overlap between different closed contours representative of different locations.

Embodiments of the present invention may also relate to a programmable electrical system comprising a plurality of addressable elements and a processing unit in accordance with embodiments of the present invention.

In a second aspect, the present invention also relates to a method for configuring a programmable electrical system in a building, in which the programmable electrical system comprises a plurality of addressable elements. The method comprises providing an interactive graphical user interface to a user, in which the providing the interactive graphical user interface comprises:
- rendering a graphical map in the graphical user interface, on which graphical map the addressable elements are represented,
- graphically representing, in a single view, a plurality of locations in the building by corresponding contours on the graphical map,
- enabling the user, i.e. receiving an input from the user, to add, remove and move a closed contour representative of a location in the building on the graphical map,
- assigning a location to an addressable element, depending on whether a graphical representation of said addressable element is contained within the closed contour graphically representing said location on said graphical map, and
- storing at least one data container comprising a definition of a location, of a closed contour associated with the location and of addressable elements assigned to that location, wherein each data container of the at least one data container is an independently accessible and referenceable data object
- relating to, e.g. comprising or consisting of definitions of, (only) a single corresponding location and data associated with that location.

In a third aspect, the present invention also relates to a computer program product adapted for executing the steps of a method in accordance with embodiments of the second aspect of the present invention, when the computer program product is run on a computer.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a programmable electrical system comprising a processing unit in accordance with embodiments of the present invention.
FIG. 2 illustrates an exemplary graphical user interface comprising a display area for displaying a graphical map, in which such graphical user interface can be provided by embodiments of the present invention.
FIG. 3 shows a graphical representation of a plurality of locations on a graphical map, as can be provided by embodiments of the present invention.
FIG. 4 illustrates a user-guided construction of a polygon forming a contour representative of a location, in which this user-guided construction relates to embodiments of the present invention.
FIG. 5 illustrates a user-guided construction of a rectangular box forming a contour representative of a location, in which this user-guided construction relates to embodiments of the present invention.
FIG. 6 illustrates a user-guided contour reshaping action relating to embodiments of the present invention; in which a corner point of a contour is moved.
FIG. 7 illustrates another user-guided contour reshaping action relating to embodiments of the present invention, in which corner points are added and subsequently moved in a contour.
FIG. 8 illustrates another user-guided contour reshaping action relating to embodiments of the present invention, in which a corner point is removed from a contour.
FIG. 9 illustrates another user-guided contour reshaping action relating to embodiments of the present invention, in which one or more corners can be removed simultaneously.
FIG. 10 illustrates another user-guided contour reshaping action relating to embodiments of the present invention, in which one or more corners can be removed simultaneously.
FIG. 11 shows a user-guided action for repositioning a representation of at least one addressable element and/or behaviour pattern on a graphical map in accordance with embodiments of the present invention.
FIG. 12 shows a user-guided reshaping action for reshaping a contour that causes reassignment of an addressable element or behaviour pattern to a different location, in accordance with embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect, the present invention relates to a processing unit for controlling a programmable electrical system of a building, in which such programmable electrical system comprises a plurality of addressable elements.

Embodiments of the present invention also relate to a programmable electrical system comprising a plurality of addressable elements and a processing unit in accordance with embodiments of the present invention.

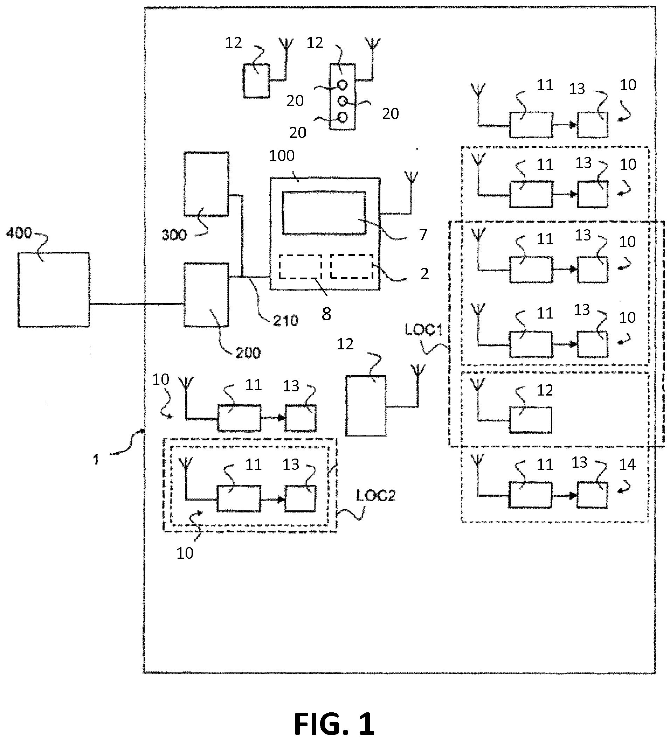

FIG. 1 shows an exemplary programmable electrical system 1 in accordance with embodiments of the present invention, comprising a plurality of addressable elements 10,12,14 and a processing unit 100 in accordance with embodiments of the present invention. The addressable elements may comprise output devices 10 having a controllable function that can be controlled by a control signal, such as equipment items. The addressable elements may comprise controller devices 12 for generating an input signal to the control system, e.g. for providing an input to a processing unit 100 that controls the generation of control signals for the output devices. It is to be noted that a single addressable element is not necessarily limited to having solely an input function or solely an output function, but such addressable element 14 can involve a combination of both. For example, an alarm terminal may have controllable indicator lights, a screen capable of displaying a message in accordance with a control signal and/or a controllable speaker or buzzer, while also comprising elements capable of generating an input for the processing unit, e.g. a keypad, an input signal obtained from a touch interface, a voice recognition system or sound sampler, a face recognition system or camera and/or a fingerprint scanner.

Each addressable element 10,12,14 may comprise a data communication interface module, e.g. having a data transmitter and/or receiver capability generally depicted by an antenna symbol. Such data communication interface module may be adapted for receiving and/or transmitting data, for example via a wireless communication channel, a powerline communication channel, a dedicated communication bus, a wired or wireless network connection, e.g. an Ethernet interface and/or an infrared communication link.

An addressable element 10,14 capable of acting as a controlled output may comprise an actuator or other controllable element, e.g. a light. An addressable element may for example comprise a driver 11, e.g. a relay, actuator, control circuit or the like, for driving a dynamic element 13 of the electrical system 1. Such dynamic element 13 may for example comprise a terrace awning, a shutter, venetian blinds, a light, a ventilation system, a cooler, a heater, an air conditioning system, a speaker, a display, a door, a gate, a latch, a lock, a siren or other automated or automatable devices for programmable electrical systems 1 for buildings as known in the art.

An addressable element 12,14 capable of acting as an input for the control system may comprise, for example, at least one switch or button 20. The input-capable element 12,14 may comprise a fixed or persistent element of the building, e.g. a wall-mounted switch, control panel or touch screen, or may comprise a portable element, e.g. a remote control device. The input-capable element 12,14 may be a dedicated device, e.g. a switch, or a general purpose device programmed or configured to act as an input device for the electrical system 1, e.g. implemented in a software for running on a smartphone, tablet or computer.

All addressable elements 10,12,14 may communicate by the use of one and the same communication protocol, or alternatively, several different communication protocols may be used, e.g. using appropriate communication gateways or devices having communication capabilities for multiple supported protocols.

For example, such programmable electrical system 1 may comprise a communication infrastructure for relaying control information from an addressable element 12,14 having input capabilities to the processing unit 100 and from the processing unit 100 to an addressable element 10,14 having output capabilities.

The processing unit 100 may comprise one or more centralized or decentralized processors. The processing unit 100 may comprise a communication bus. An addressable element 10,12,14 may be operably connected to the communication bus, e.g. by a communication module integrated in the addressable element. An addressable element 10,12,14 may also be connected to, e.g. wired directly to, an input/output module for providing an interface between the addressable element 10,12,14 and the communication bus. For example, the processing unit 100 may comprise, or may be comprised in, a central control box. The input/output module may also be comprised in such central control box.

Embodiments of the present invention relate to a processing unit 100 for controlling a programmable electrical system 1 of a building, in which such programmable electrical system 1 comprises a plurality of addressable elements 10,12,14.

The processing unit 100 comprises an interaction interface 7 for enabling a user to interact with a graphical user interface, e.g. to interact with the interaction interface 7 using the graphical user interface. For example, the processing unit 100 may comprise input/output means, such as a touch screen, a computer monitor, a display device, a mouse, a keyboard, a trackpad, a joystick, a voice control interface, or similar human interaction devices. The interaction interface 7 may render the graphical user interface and enable user feedback via such input/output means. However, preferably, the processing unit 100 may comprise a data network interface for communicating with a remote user terminal 300, such as a personal computer, over a local area network 210. Furthermore, the processing unit 100 may alternatively or additionally communicate with a remote user terminal, e.g. a personal computer, via a wide area network 400, e.g. an internet connection, e.g. connected to the local area network 210 via an interface device 200, e.g. a router, a modem or a gateway. The interaction interface 7 may thus render the graphical user interface and enable user feedback via a connection to a computer connected to the processing unit 100 via a local or wide area network 210, 400. The processing unit 100 may also comprise a data network interface for communicating with a portable general purpose computing device, such as a smartphone or a tablet, e.g. via a WiFi network connection or a mobile phone carrier data network. The interaction interface may thus render the graphical user interface and enable user feedback via a connection to a portable general purpose computing device such as a smartphone or a tablet.

The interaction interface 7 may provide the graphical user interface using a web interface and/or using a server for cooperating with a dedicated app or software package for executing on a user terminal. The interaction interface 7 may for example use a hypertext language such as HTML, e.g. HTML5, a client-side parsed or executed code, e.g. using a scripting language such as JavaScript, and/or a server-side parsed or executed code, e.g. a PHP, Java, Node.JS or similar languages. The interaction interface 7 may provide the graphical user interface using a server component executing locally on the processing unit 100 and transmission of executable or interpretable code for executing or evaluating remotely on the user terminal.

The interaction interface 7 is adapted for rendering a graphical map in the graphical user interface, on which graphical map the addressable elements 10,12,14 are graphically or textually represented.

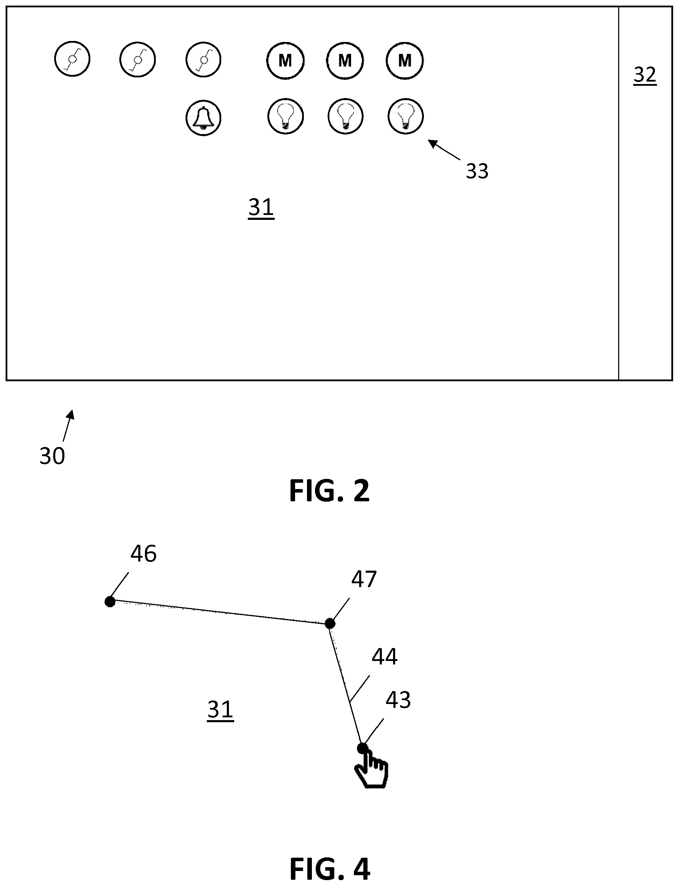

Referring to FIG. 2, an exemplary graphical user interface 30 is shown comprising a display area displaying the graphical map 31, e.g. a floorplan of the building, e.g. an abstraction of the floorplan enriched with contextual information. The addressable elements 10,12,14 of the programmable electrical system 1 may be provided by a graphical or textual representation 33 on this graphical map 31, e.g. by icons 33.

The graphical user interface 30 may also comprise at least one menu 32 for displaying selectable actions. For example, such menu 32 may be context sensitive, e.g. may allow a user to navigate through an organized structure of dependent views of possible actions, and/or may comprise interface elements that are sensitive to a selected element in the graphical map 31.

For example, in the menu 32, the user may be presented with an option(s) relating to editing and/or management of locations LOC1,LOC2, an option(s) relating to editing and/or management of the addressable elements 10,12,14, and/or an option(s) relating to the configuration of behaviour linking addressable elements 10,12,14 into coordinated actions.

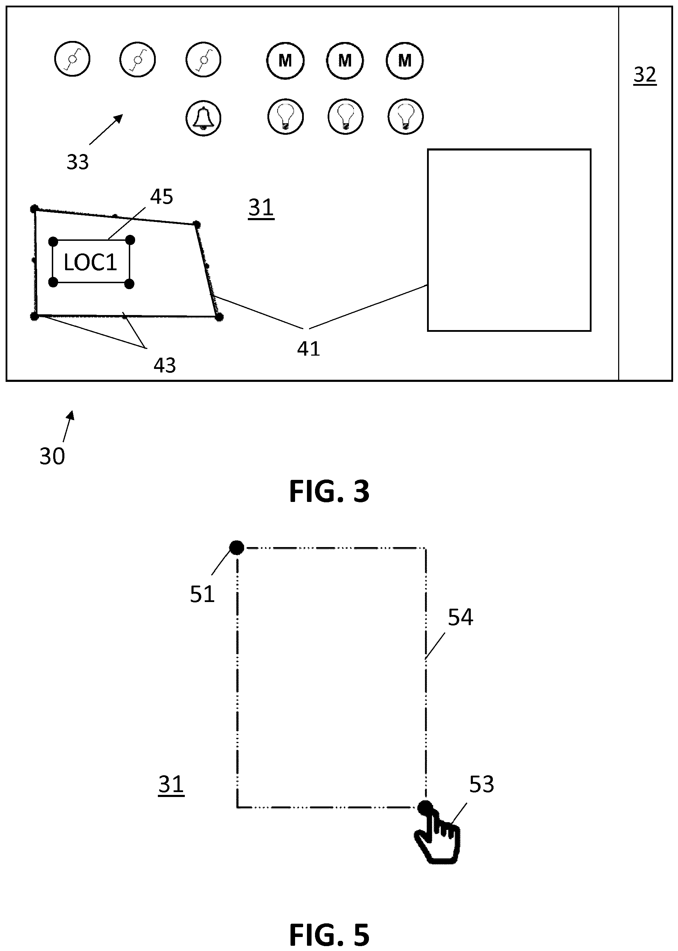

Referring to FIG. 3, the interaction interface 7 is adapted for graphically representing a plurality of locations LOC1,LOC2 in the building by corresponding contours 41 on the graphical map 31.

The interaction interface may also be adapted for enabling the user to configure a behavior pattern that links addressable elements 10,12,14 into coordinated actions, in which this behavior pattern may be represented on the graphical map 31.

The interaction interface 7 is adapted for enabling the user to add, remove and move a contour 41 representative of a location LOC1,LOC2 in the building on the graphical map 31 using the graphical user interface 30, e.g. using a combination of selection of menu options, e.g. in menu 32, and clicking and/or dragging a contour 41 or part thereof.

For example, the interaction interface 7 may enable the user to add a new contour 41, and corresponding location LOC1,LOC2, by drawing a polygon line by line. For example, as illustrated in FIG. 4, after activation of such draw-by-line mode for adding a contour 41, a first click in the area used for displaying the graphical map 31 may indicate a first corner 46 of the polygon at the location where this first click occurred, while continuously updating a line segment from that first corner 46 to the present cursor location until a second click confirms the location of a second corner 47 of the polygon at the location where this second click occurred. Then, likewise, a line segment 44 may be continuously updated from that second corner 47 to the present cursor location 43 until a further click confirms a next corner. Thus, a polygon contour 41 may be constructed line segment by line segment until the contour 41 is closed by clicking on a previously defined corner 46,47 that allows a closed contour 41 to be formed, e.g. by clicking on, or sufficiently near, the first corner 46. Alternatively, or additionally, the contour 41 being constructed can be automatically closed by pressing a hotkey, clicking another mouse button than used for adding points, or another suitable user-initiated interaction event, after which action the last defined corner may be automatically connected to the first defined corner 46 by a straight line segment to close the contour 41. Furthermore, a user event may be defined for cancelling the last defined corner point and/or for cancelling the contour construction process.

The interaction interface 7 may be adapted for guiding motion by soft and/or hard constraints, e.g. such as to aid the user in drawing straight lines. For example, the user may only be allowed to draw straight lines at right angles with respect to a coordinate grid of the graphical map 31, to only draw lines at particular angles with respect to the coordinate grid, e.g. at 45°, 30°, 22.5°, 18°, 15° or 10° intervals with respect to a reference horizontal coordinate axis. In another example, the position when registering a corner 46,47 and while on-the-fly updating a preview line segment may be constrained to an predefined integer multiple of a minimum displacement unit defined on the coordinate grid of the graphical map 31.

Additionally or alternatively, the interaction interface 7 may enable the user to add a new contour, and corresponding location, by providing another drawing mode. For example, as illustrated in FIG. 5, such drawing mode may allow the user to define a new contour in the form of a rectangular box aligned to the axes of the coordinate grid. For example, such box may be defined by first clicking on a first corner 51 of the rectangular box. The shape of a box 54 having this first corner and another diagonally opposed corner at the present location of a cursor 53 may then be continuously updated until the shape of the created box is confirmed by clicking at the intended location of corner diagonally opposed to the first corner 51.

Other drawing modes as known in the art may also be provided, additionally or alternatively, e.g. a drawing mode based on contours composed of Bezier curves, and/or on circular or elliptic contours.

The interaction interface 7 may furthermore be adapted for assigning a location LOC1,LOC2 to an addressable element 10,12,14 if the graphical or textual representation 33 of the addressable element 10,12,14 is contained within the corresponding contour.

A location LOC1,LOC2, however, can also be assigned to an addressable element 10,12,14 by indicating which location LOC1,LOC2 the addressable element 10,12,14 belongs to, e.g. by using a user control presented in the menu 32 when the addressable element 10,12,14 is selected or added.

Hence, there may be a plurality of mechanisms to assign a location LOC1,LOC2 to the addressable element 10,12,14, e.g. there may be two possible ways to assign a location LOC1,LOC2 to the addressable element 10,12,14. According to one exemplary way, the addressable element 10,12,14 may be placed on the graphical map 31 when the addressable element 10,12,14 is chosen from the menu 32 without indicating a location LOC1,LOC2, e.g. may be placed at a predetermined default location or at a random location on the graphical map 31, after which the addressable element 10,12,14 can be dragged into the required location LOC1,LOC2. According to another exemplary way, the addressable element 10,12,14 may be put directly in the required location LOC1,LOC2 on the graphical map 31 when the addressable element 10,12,14 is chosen from the menu 32 and, in that menu 32, also the location LOC1,LOC2 is indicated.

The defined locations LOC1, LOC2 and corresponding addressable elements 10,12,14, may be used in a user interface, e.g. may be represented on a touch screen, a smart phone and/or a tablet, to enable a user to control the addressable elements 10,12,14.

Likewise, the interaction interface 7 may be adapted for assigning a location LOC1,LOC2 to a behavior pattern if the representation of the behavior pattern on the graphical map 31 is contained within the contour 41 corresponding to said location LOC1,LOC2.

By convention, addressable elements 10,12,14 and/or behavior patterns that are not enclosed by any contour 41 representative of a location LOC1,LOC2 may be assigned to a default location, e.g. a virtual location, that is not necessarily represented on the graphical map 31 by any corresponding contour 41.

When a new contour is created, all addressable elements 10,12,14 and/or behaviour patterns being represented in the area circumscribed by the newly created contour 41 may be assigned to the new location LOC1,LOC2 corresponding to the newly created contour.

Furthermore, the interaction interface 7 may be adapted for enabling a user to move the graphical or textual representation 33 of an addressable element 10,12,14 (or of a behaviour pattern) in the graphical map 31. For example, a drag and drop interface may allow such representation 33 to be repositioned. Likewise, a number of such representations 33 may be jointly selected, e.g. by drawing a selection rectangle around the set of graphical/textual representations 33 of the addressable elements 10,12,14, or by performing another multi-selection operation as well known in the art.

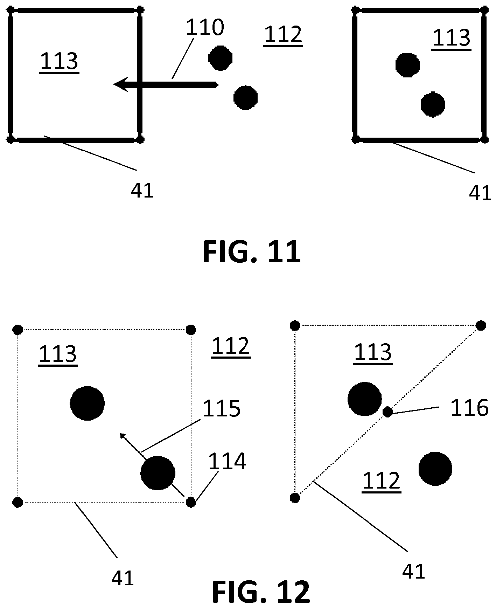

Referring to FIG. 11, the representation(s) of one addressable element 10,12,14 or of a group of addressable elements 10,12,14 (and/or of one or more behaviour patterns) may be repositioned 110 in response to a user action. For example, as shown, the representation of the addressable element(s) 10,12,14, e.g. icons, may be moved from a region 112 outside a contour 41 to a region 113 inside the contour 41. Thus, the addressable element or addressable elements 10,12,14 may be, in response to this repositioning, assigned to the location LOC1,LOC2 corresponding to this contour 41.

Advantageously, this allows an addressable element 10,12,14 or behaviour pattern to be easily logically assigned to a location LOC1,LOC2 and/or logically removed from a location LOC1,LOC2 by dropping it respectively inside or outside the corresponding contour 41.

The interaction interface 7 may be adapted for selecting a contour 41, e.g. by clicking on the contour 41. For example, different states, such as selected and unselected, or such as selected, unselected and editing, may be presented in a visually different manner by altering a mode of representation of the contour 41, e.g. altering a contour color or line style and/or altering a fill color or fill style of the area circumscribed by the contour 41.

The interaction interface 7 may be adapted for assigning an identifier string to a location LOC1,LOC2, e.g. to the location LOC1,LOC2 corresponding to the selected contour 41. For example, selecting a contour 41 may open a contextual menu, dialog or window showing present information relating to the location LOC1,LOC2 that corresponds to the selected contour 41, in which this contextual menu, dialog or window provides an interaction mechanism for allowing the user to change such information, e.g. to change a designated identifier string. Likewise, the interaction interface may be adapted for assigning a graphical representation, such as an icon, to the location LOC1,LOC2 corresponding to the selected contour 41.

After finalizing a step of creating a contour 41 and associated location LOC1,LOC2, the user may be prompted to provide an identifier string and/or graphical representation of the location LOC1,LOC2, or a default value may be assigned to such data fields. For example, a default identifier string may be assigned and a creation mode may terminate in a state in which the created contour 41 is preselected such as to display the contextual menu, dialog or window to enable the user to change such default immediately.

The identifier string and/or the graphical representation may be displayed as a label 45 on the graphical map 31. For example, such label 45 may be movable relative to the related contour 41 in order to avoid that relevant addressable elements 10,12,14 contained in the contour 41 are obscured.

The interaction interface 7 may be adapted for enabling the user to remove a contour 41, e.g. together with removing references to the corresponding location LOC1,LOC2. For example, a contour 41 may be selected, and a hotkey may be used or a menu option may be selected to initiate the removal of the contour 41.

The interaction interface 7 may be adapted for enabling the user to move a contour 41 on the graphical map 31 using the graphical user interface 30. For example, a contour 41 may be moved, e.g. by dragging the contour 41, such as by pressing on a line segment 44 of the contour 41 where it does not display a special purpose handle, dragging the contour 41 to a new location and depressing the held line segment 44 at the new location.

Preferably, a label 45 may move along with the related contour 41 when this contour 41 is moved.

Preferably, a representation of an addressable element 10,12,14 (or behaviour pattern) assigned to a location LOC1,LOC2, e.g. contained within the contour 41 corresponding to that location LOC1,LOC2, may move along with the related contour 41 when this contour 41 is moved. Thus, a location LOC1,LOC2 may be moved together with its depicted contents in a simple and easy to perform operation.

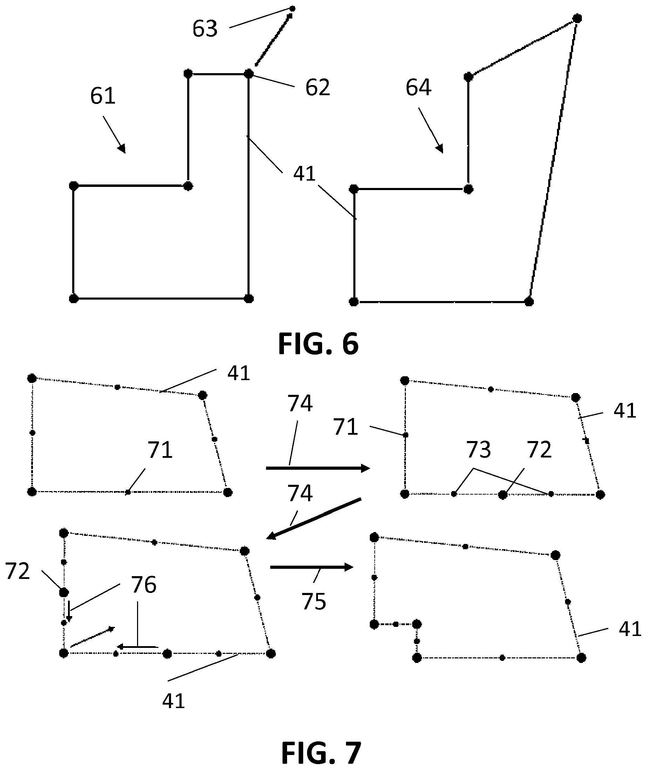

The interaction interface 7 may be adapted for enabling the user to resize and/or reshape a contour 41. For example, a corner or line segment of the contour may be dragged to a new position. FIG. 6 illustrates such reshaping action, in which an initial contour 61 is transformed, e.g. by dragging a corner 62 to a new location 63, into a final contour 64.

Other reshaping actions may alternatively or additionally be provided, e.g. adding a corner to a contour by subdividing a line segment of a contour into two line segments, e.g. such that the union of these two line segments forms the original line segment and such that the two line segments are joined by the newly created corner. For example, such action may be initiated by the user by double-clicking at a location on the original line segment where the new corner is intended to appear.

Alternatively, as shown in FIG. 7, dummy corners 71, e.g. graphic handles that are visually presented differently as compared to graphic handles for the corners of the contour, may be depicted at a midpoint of each line segment. These may be converted 74 into an actual corner point of the contour, for example in response to a user action such as double-clicking on a dummy corner. The newly created line segments, the union of which forms the original line segment that was divided, may then also be presented with dummy corners 73.

While reference is made to corners, or, equivalently, to actual corners, for sake of clarity, it shall be clear that this does not necessarily refer to geometrical corners, e.g. after a transformation 74, newly created line segments may be joined at an angle of 180° by such corner. Rather, the corner refers to an anchor point where line segments of the contour representation are joined. For example, FIG. 7 illustrates a step 75 that can be performed after creating two additional corners 72 by respectively subdividing two original line segments, in which the newly created corners 72 are moved 76 independently by a user action to reshape the contour.

Likewise, references to 'corner' may relate, equivalently, to anchor points for defining non-polygon shapes, e.g. anchor points defining a Bezier curve shape.

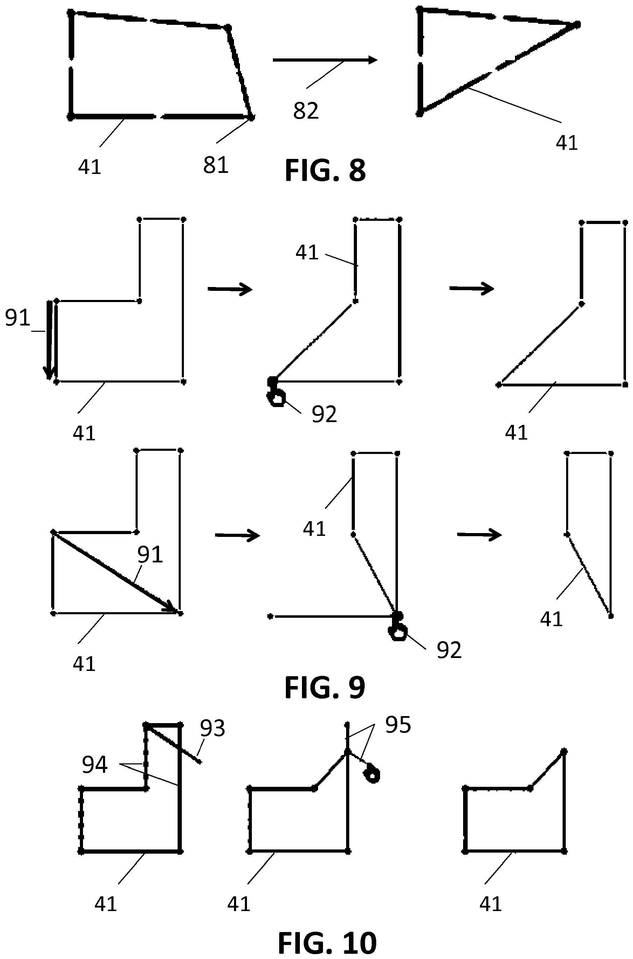

Referring to FIG. 8, another reshaping action may relate to a removal 82 of a corner 81, e.g. such that two line segments adjacent to the corner are removed and replaced by a line segment joining the other two corners that were adjacent to each one of the two line segments respectively. For example, an error message may be generated when the user attempts to reduce a polygon shape that has three corners, i.e. a triangle, to less than three corner points.

Referring to FIG. 9, another reshaping action is demonstrated in which one or more corners can be removed simultaneously. For example, a drag operation 91, which could also be used to move a corner, may end by releasing 92 the dragged corner on, or sufficiently near, another corner. The dragged corner and the other corner onto which it was dragged may thus be replaced by a single corner, and any line segment connecting these two corners may be removed. In case that the dragged corner and the other corner are not adjacent with respect to the contour graph, e.g. were not directly connected by a single line segment of the contour, any line segment and any corner that were located in between the dragged and the other corner may be removed in a single operation.

Referring to FIG. 10, when a corner is moved 93 over a line segment such as to create a crossover, e.g. an intersection point, of two line segments 94 of the contour, the dragged corner may be replaced by this intersection point, and a line segment or connected set of line segments that both starts at one end in the intersection point and ends at another end in the intersection point may be removed, as well as corners connecting such connected set of line segments. Since the contour is a closed shape, generally two of such connected sets may exist, and, for example, the shortest such connected set may be removed.

The interaction interface 7 may also be adapted for detecting collisions between contours 41, e.g. for preventing an overlap between different contours 41 representative of different locations LOC1,LOC2, when adding, moving, reshaping and/or resizing contours 41. For example, an interactive drag operation may be aborted when a collision is detected, or may be constrained to reject a move into a state of collision.

Preferably, graphical and/or textual representations of addressable elements 10,12,14 or behaviour patterns, e.g. contained or not contained within the contour 41 corresponding to that location LOC1,LOC2, may remain stationary on the graphical map 31 while resizing and/or reshaping the contour 41. Thus, an addressable element 10,12,14 or behaviour pattern may be easily removed from being logically assigned to a location LOC1,LOC2 by reshaping and/or resizing the contour 41 representative of the location LOC1,LOC2 such as to exclude the addressable element 10,12,14 from the area circumscribed by the contour. Likewise, an addressable element 10,12,14 or behaviour pattern may be easily logically assigned to a location LOC1,LOC2 by reshaping and/or resizing the contour 41 representative of the location LOC1,LOC2 such as to include the addressable element 10,12,14 in the area circumscribed by the contour 41.

Referring to FIG. 12, a reshaping action, e.g. dragging 115 a corner 114 of the contour to a new location 116, may cause the graphical/textual representation 33 of an addressable element 10,12,14 to change from being in a region 112 outside the area circumscribed by the contour 41 to being in a region 113 inside the area circumscribed by the contour 41, or vice versa. Thus, the location LOC1,LOC2 of the addressable element 10,12,14 may be updated accordingly.

Referring again to FIG. 1, a processing unit 100 in accordance with embodiments of the present invention also comprises a storage memory 2 for storing at least one data container that comprises a definition of a location LOC1,LOC2, of a contour 41 associated with this location LOC1,LOC2, and of addressable elements 10,12,14 assigned to the location LOC1,LOC2. Furthermore, according to further embodiments of the invention, such data container may comprise a definition of behavior patterns between addressable elements 10,12,14 assigned to the location LOC1,LOC2. The definition of the location LOC1,LOC2 may for example comprise the text string identifier and/or graphical representation of the location LOC1,LOC2 . The data container may further comprise relative positioning information of the representations 33 of addressable elements 10,12,14 and/or behaviour patterns with respect to the contour 41. For example, a single data container may be a independently accessible and referenceable data object relating to a single location and its associated data. The storage memory 2 may comprise a RAM memory, or may comprise a persistent memory, such as a flash memory, a magnetic hard disk, a solid state hard disk, or may comprise a portable data carrier, such as a CD-ROM, a DVD, a magnetic floppy disk, a USB data carrier, and the like. The data storage may also comprise a network interface for accessing remotely stored data, e.g. on an external data server.

It is an advantage of embodiments of the present invention that data containers, comprising combinations of particular addressable elements 10,12,14 in a particular location LOC1, LOC2 and, optionally, particular behaviour patterns associated with that location, can be stored such as to form a kind of data container library. Data containers in such library may advantageously be reused at any time. Therefore, time may be saved for installers or users when programming the programmable electrical system 1, since the combinations contained within these data containers do not have to be defined repeatedly. Instead, the data containers can be used, and reused, as such for configuring the addressable elements 10,12,14 in the programmable electrical system 1.

According to preferred embodiments, the interaction interface 7 may be adapted for cutting, copying and/or saving data relating to, and data associated with, a location of the plurality of locations LOC1,LOC2 graphically represented on the graphical map 31 in the at least one data container.

The interaction interface 7 may also be adapted for pasting and/or loading data relating to and data associated with a location LOC1,LOC2 to be graphically represented on the graphical map 31 from the at least one data container.

It is an advantage of particular embodiments of the present invention that a good ease of use and a good time efficiency can be experienced by an installer or user when configuring addressable elements 10,12,14 in a programmable electrical system 1, e.g. because the defined data containers can be easily and efficiently reused at any time.

The processing unit 100 may also comprise a control interface 8 adapted for rendering a control user interface to enable a user to control the addressable elements 10,12,14, e.g. by activating the behaviour patterns. This control user interface may be rendered in a location-sensitive manner, e.g. by sensing a location where the user is present and/or by allowing the user to select a location of interest. The actions available to the user in this control interface may thus be grouped by location, where this location is advantageously assigned by the interaction interface 7 as described hereinabove.

In a second aspect, the present invention also relates to a method for configuring a programmable electrical system 1 in a building, in which this programmable electrical system 1 comprises a plurality of addressable elements 10,12,14, e.g. as described hereinabove in relation to FIG. 1. The method comprises providing an interactive graphical user interface 30 to a user, in which this providing of the interactive graphical user interface 30 comprises:
- rendering a graphical map 31 in the graphical user interface 30, on which graphical map 31 the addressable elements 10,12,14 are represented,
- graphically representing a plurality of locations LOC1,LOC2 in the building by corresponding contours 41 on the graphical map 31,
- enabling the user to add, remove and move a contour 41 representative of a location LOC1,LOC2 in the building on the graphical map 31, assigning a location LOC1,LOC2 to an addressable element 10,12,14, and
- storing at least one data container comprising a definition of a location LOC1,LOC2, of a contour 41 associated with the location LOC1,LOC2 and of addressable elements 10,12,14 assigned to that location LOC1,LOC2.

Further details regarding a method in accordance with embodiments of the present invention, e.g. further details relating to essential features and/or to optional features, shall be clear to the person skilled in the art in the light of the description hereinabove relating to a device in accordance with embodiments of the first aspect of the present invention. Particularly, at least one step of a method in accordance with embodiments may relate to a function performed by a processing unit in accordance with embodiments as described hereinabove.

In a third aspect, the present invention also relates to a computer program product adapted for executing the steps of a method in accordance with embodiments of the present invention when the computer program product is run on a computer.

## Claims

1. A processing unit (100) for controlling a programmable electrical system (1) of a building, said programmable electrical system (1) comprising a plurality of addressable elements (10,12,14), the processing unit (100) comprising:
an interaction interface (7) for receiving an input from a user to interact with a graphical user interface (30), said interaction interface (7) being adapted for:
- rendering a graphical map (31) in said graphical user interface (30), on which graphical map (31) said addressable elements (10,12,14) are represented,
- graphically representing a plurality of locations (LOC1,LOC2) in said building by corresponding contours (41) on said graphical map (31),
- receiving an input from said user to add, remove and move a contour (41) representative of a location (LOC1,LOC2) in said building on said graphical map (31) using said graphical user interface (30), and
- assigning a location (LOC1,LOC2) in the building, graphically represented on the graphical map by the corresponding contour, to an addressable element (10,12,14),
and a storage memory (2) for storing at least one data container, **characterized in that**
non-intersecting closed contours are graphically representing the plurality of locations in said building in a single view on said graphical map, a location in the building, graphically represented on the graphical map by the corresponding contour, is logically assigned to an addressable element if a graphical representation (33) of said addressable element is contained within the closed contour graphically representing said location on said graphical map, and
the at least one data container comprises a definition of a location (LOC1,LOC2) in the building, of a closed contour (41) associated with said location (LOC1,LOC2) in the building and of addressable elements (10,12,14) assigned to said location (LOC1,LOC2) in the building, wherein each data container of the at least one data container is an independently accessible and referenceable data object relating to a single, corresponding one location of said plurality of locations in the building and data associated with said location in the building.

2. The processing unit (100) of claim 1, wherein said interaction interface (7) is adapted for cutting, copying and/or saving data relating to and data associated with a location of said plurality of locations (LOC1,LOC2) in the building graphically represented on the graphical map (31) in said at least one data container.

3. The processing unit (100) of claim 2, wherein said interaction interface (7) is furthermore adapted for pasting and/or loading data relating to and data associated with a location (LOC1,LOC2) in the building to be graphically represented on the graphical map (31) from said at least one data container.

4. The processing unit (100) of any of the previous claims, wherein said interaction interface (7) is adapted for receiving an input from said user to configure a behavior pattern that links addressable elements (10,12,14) into coordinated actions, in which said behavior pattern is represented on said graphical map (31).

5. The processing unit (100) of claim 4, wherein said interaction interface (7) is adapted for assigning a location (LOC1,LOC2) in the building to a behavior pattern if said representation of the behavior pattern on the graphical map (31) is contained within the closed contour (41) corresponding to said location (LOC1,LOC2) in the building.

6. The processing unit (100) of claim 5, wherein the data container further comprises a definition of behavior patterns between addressable elements (10,12,14) assigned to said location (LOC1,LOC2) in the building.

7. The processing unit (100) of any of the previous claims, comprising a control interface (8) adapted for rendering a control user interface in a location-sensitive manner and adapted for receiving an input from the user to control said addressable elements (10,12,14), wherein actions that are available to the user in this control interface are grouped by said location (LOC1,LOC2) in the building as assigned by said interaction interface (7).

8. The processing unit (100) of any of the previous claims, wherein said interaction interface (7) is adapted for receiving an input from the user to move the representation (33) of an addressable element (10,12,14) in the graphical map (31).

9. The processing unit (100) of claim 8, wherein said interaction interface (7) is adapted for assigning a location (LOC1,LOC2) in the building to at least one addressable element (10,12,14) in response to a user action for moving the representation (33) of the at least one addressable element (10,12,14) from a region (112) outside a closed contour (41) to a region (113) inside the closed contour (41) or vice versa.

10. The processing unit (100) of any of the previous claims, wherein said interaction interface (7) is adapted for, when a new closed contour (41) is created, assigning all addressable elements (10,12,14) being represented in the area circumscribed by the newly created closed contour (41) to the new location (LOC1,LOC2) corresponding to the newly created closed contour (41).

11. The processing unit (100) of any of the previous claims, wherein said interaction interface (7) is adapted for receiving an input from the user to move a closed contour (41) on the graphical map (31), wherein any graphical and/or textual representation (33) of an addressable element (10,12,14) assigned to the location that corresponds to the closed contour (41) is moved along with said closed contour (41).

12. The processing unit (100) of any of the previous claims, wherein said interaction interface (7) is adapted for receiving an input from the user to resize and/or reshape a closed contour (41) and for keeping said representations (33) of addressable elements (10,12,14) stationary on the graphical map (31) while resizing and/or reshaping the closed contour (41).

13. A programmable electrical system (1) comprising a plurality of addressable elements (10,12,14) and a processing unit (100) according to any of the previous claims.

14. A method for configuring a programmable electrical system (1) in a building, said programmable electrical system (1) comprising a plurality of addressable elements (10,12,14), the method comprising providing an interactive graphical user interface (30) to a user, wherein said providing the interactive graphical user interface (30) comprises:
- rendering a graphical map (31) in said graphical user interface (30), on which graphical map (31) said addressable elements (10,12,14) are represented,
- graphically representing a plurality of locations (LOC1,LOC2) in said building by corresponding contours (41) on said graphical map (31),
- receiving an input from said user to add, remove and move a contour (41) representative of a location (LOC1,LOC2) in said building on said graphical map (31),
- assigning a location (LOC1,LOC2) in the building, graphically represented on the graphical map by the corresponding contour, to an addressable element (10,12,14), and
- storing at least one data container,
**characterized in that**
non-intersecting closed contours are graphically representing the plurality of locations in said building in a single view on said graphical map,
a location in the building, graphically represented on the graphical map by the corresponding contour, is logically assigned to an addressable element if a graphical representation (33) of said addressable element is contained within the closed contour graphically representing said location on said graphical map, and
the at least one data container comprises a definition of a location (LOC1,LOC2) in the building, of a closed contour (41) associated with the location (LOC1,LOC2) in the building and of addressable elements (10,12,14) assigned to that location (LOC1,LOC2) in the building, wherein each data container of the at least one data container is an independently accessible and referenceable data object relating to a single, corresponding one location of the plurality of locations in the building and data associated with said location in the building.

15. A computer program product adapted for executing the steps of a method in accordance with claim 14 when said computer program product is run on a computer.

## Patentansprüche

1. Verarbeitungseinheit (100) zum Steuern eines programmierbaren elektrischen Systems (1) eines Gebäudes, wobei das programmierbare elektrische System (1) mehrere adressierbare Elemente (10, 12, 14) umfasst, wobei die Verarbeitungseinheit (100) Folgendes umfasst:
eine Interaktionsschnittstelle (7) zum Empfangen einer Eingabe von einem Benutzer, um mit einer grafischen Benutzerschnittstelle (30) zu interagieren, wobei die Interaktionsschnittstelle (7) für Folgendes angepasst ist:
- Rendern einer grafischen Karte (31) in der grafischen Benutzerschnittstelle (30), wobei auf der grafischen Karte (31) die adressierbaren Elemente (10, 12, 14) dargestellt sind,
- grafisches Darstellen mehrerer Orte (LOC1, LOC2) in dem Gebäude durch entsprechende Konturen (41) auf der grafischen Karte (31),
- Empfangen einer Eingabe von dem Benutzer, um eine Kontur (41), die einen Ort (LOC1, LOC2) in dem Gebäude darstellt, auf der grafischen Karte (31) unter Verwendung der grafischen Benutzerschnittstelle (30) hinzuzufügen, zu entfernen und zu verschieben, und
- Zuweisen eines Ortes (LOC1, LOC2) in dem Gebäude, der auf der grafischen Karte durch die entsprechende Kontur grafisch dargestellt ist, zu einem adressierbaren Element (10, 12, 14),
und einen Speicher (2) zum Speichern von wenigstens einem Datencontainer, **dadurch gekennzeichnet, dass**
sich nicht überschneidende geschlossene Konturen die mehreren Orte in dem Gebäude in einer einzigen Ansicht auf der grafischen Karte grafisch darstellen,
ein Ort in dem Gebäude, der auf der grafischen Karte durch die entsprechende Kontur grafisch dargestellt ist, einem adressierbaren Element logisch zugewiesen wird, falls eine grafische Darstellung (33) des adressierbaren Elements innerhalb der geschlossenen Kontur enthalten ist, die den Ort auf der grafischen Karte grafisch darstellt, und
der wenigstens eine Datencontainer eine Definition eines Ortes (LOC1, LOC2) in dem Gebäude, einer geschlossenen Kontur (41), die dem Ort (LOC1, LOC2) in dem Gebäude zugehörig ist, und von adressierbaren Elementen (10, 12, 14), die dem Ort (LOC1, LOC2) in dem Gebäude zugewiesen sind, umfasst, wobei jeder Datencontainer des wenigstens einen Datencontainers ein unabhängig zugängliches und referenzierbares Datenobjekt ist, das sich auf einen einzelnen, entsprechenden Ort der mehreren Orte in dem Gebäude und Daten, die dem Ort in dem Gebäude zugehörig sind, bezieht.

2. Verarbeitungseinheit (100) nach Anspruch 1, wobei die Interaktionsschnittstelle (7) zum Ausschneiden, Kopieren und/oder Speichern von Daten, die sich auf einen Ort der mehreren Orte (LOC1, LOC2) in dem auf der grafischen Karte (31) grafisch dargestellten Gebäude beziehen und diesem zugehörig sind, in dem wenigstens einen Datencontainer angepasst ist.

3. Verarbeitungseinheit (100) nach Anspruch 2, wobei die Interaktionsschnittstelle (7) ferner zum Einfügen und/oder Laden von Daten, die sich auf einen Ort (LOC1, LOC2) in dem auf der grafischen Karte (31) grafisch darzustellenden Gebäude beziehen und diesem zugehörig sind, aus dem wenigstens einen Datencontainer angepasst ist.

4. Verarbeitungseinheit (100) nach einem der vorhergehenden Ansprüche, wobei die Interaktionsschnittstelle (7) zum Empfangen einer Eingabe von dem Benutzer angepasst ist, um ein Verhaltensmuster zu konfigurieren, das adressierbare Elemente (10, 12, 14) zu koordinierten Aktionen verknüpft, wobei das Verhaltensmuster auf der grafischen Karte (31) dargestellt ist.

5. Verarbeitungseinheit (100) nach Anspruch 4, wobei die Interaktionsschnittstelle (7) zum Zuweisen eines Ortes (LOC1, LOC2) in dem Gebäude zu einem Verhaltensmuster angepasst ist, falls die Darstellung des Verhaltensmusters auf der grafischen Karte (31) innerhalb der geschlossenen Kontur (41) enthalten ist, die dem Ort (LOC1, LOC2) in dem Gebäude entspricht.

6. Verarbeitungseinheit (100) nach Anspruch 5, wobei der Datencontainer ferner eine Definition von Verhaltensmustern zwischen adressierbaren Elementen (10, 12, 14) umfasst, die dem Ort (LOC1, LOC2) in dem Gebäude zugewiesen sind.

7. Verarbeitungseinheit (100) nach einem der vorhergehenden Ansprüche, die eine Steuerschnittstelle (8) umfasst, die zum Rendern einer Steuerbenutzerschnittstelle auf eine ortsempfindliche Weise angepasst und zum Empfangen einer Eingabe von dem Benutzer angepasst ist, um die adressierbaren Elemente (10, 12, 14) zu steuern, wobei Aktionen, die dem Benutzer in dieser Steuerschnittstelle zur Verfügung stehen, nach dem Ort (LOC1, LOC2) in dem Gebäude gruppiert sind, wie sie durch die Interaktionsschnittstelle (7) zugewiesen sind.

8. Verarbeitungseinheit (100) nach einem der vorhergehenden Ansprüche, wobei die Interaktionsschnittstelle (7) zum Empfangen einer Eingabe von dem Benutzer angepasst ist, um die Darstellung (33) eines adressierbaren Elements (10, 12, 14) in der grafischen Karte (31) zu verschieben.

9. Verarbeitungseinheit (100) nach Anspruch 8, wobei die Interaktionsschnittstelle (7) zum Zuweisen eines Ortes (LOC1, LOC2) in dem Gebäude zu wenigstens einem adressierbaren Element (10, 12, 14) als Reaktion auf eine Benutzeraktion zum Verschieben der Darstellung (33) des wenigstens einen adressierbaren Elements (10, 12, 14) von einem Bereich (112) au ßerhalb einer geschlossenen Kontur (41) zu einem Bereich (113) innerhalb der geschlossenen Kontur (41) oder umgekehrt angepasst ist.

10. Verarbeitungseinheit (100) nach einem der vorhergehenden Ansprüche, wobei die Interaktionsschnittstelle (7) zum Zuweisen aller adressierbaren Elemente (10, 12, 14), die in der Fläche, die durch die neu erstellte geschlossene Kontur (41) umschrieben wird, dargestellt werden, zu dem neuen Ort (LOC1, LOC2), der der neu erstellten geschlossenen Kontur (41) entspricht, angepasst ist, wenn eine neue geschlossene Kontur (41) erstellt wird.

11. Verarbeitungseinheit (100) nach einem der vorhergehenden Ansprüche, wobei die Interaktionsschnittstelle (7) zum Empfangen einer Eingabe von dem Benutzer angepasst ist, um eine geschlossene Kontur (41) auf der grafischen Karte (31) zu verschieben, wobei eine beliebige grafische und/oder textuelle Darstellung (33) eines adressierbaren Elements (10, 12, 14), das dem Ort zugewiesen ist, der der geschlossenen Kontur (41) entspricht, zusammen mit der geschlossenen Kontur (41) verschoben wird.

12. Verarbeitungseinheit (100) nach einem der vorhergehenden Ansprüche, wobei die Interaktionsschnittstelle (7) zum Empfangen einer Eingabe von dem Benutzer, um eine geschlossene Kontur (41) in der Größe zu ändern und/oder umzuformen und zum stationären Beibehalten der Darstellungen (33) von adressierbaren Elementen (10, 12, 14) auf der grafischen Karte (31) angepasst ist, während die geschlossene Kontur (41) in der Größe geändert und/oder umgeformt wird.

13. Programmierbares elektrisches System (1), das mehrere adressierbare Elemente (10, 12, 14) und eine Verarbeitungseinheit (100) nach einem der vorhergehenden Ansprüche umfasst.

14. Verfahren zum Konfigurieren eines programmierbaren elektrischen Systems (1) in einem Gebäude, wobei das programmierbare elektrische System (1) mehrere adressierbare Elemente (10, 12, 14) umfasst, wobei das Verfahren ein Bereitstellen einer interaktiven grafischen Benutzerschnittstelle (30) an einen Benutzer umfasst, wobei das Bereitstellen der interaktiven grafischen Benutzerschnittstelle (30) Folgendes umfasst:
- Rendern einer grafischen Karte (31) in der grafischen Benutzerschnittstelle (30), wobei auf der grafischen Karte (31) die adressierbaren Elemente (10, 12, 14) dargestellt sind,
- grafisches Darstellen mehrerer Orte (LOC1, LOC2) in dem Gebäude durch entsprechende Konturen (41) auf der grafischen Karte (31),
- Empfangen einer Eingabe von dem Benutzer, um eine Kontur (41), die einen Ort (LOC1, LOC2) in dem Gebäude darstellt, auf der grafischen Karte (31) hinzuzufügen, zu entfernen und zu verschieben,
- Zuweisen eines Ortes (LOC1, LOC2) in dem Gebäude, der auf der grafischen Karte durch die entsprechende Kontur grafisch dargestellt ist, zu einem adressierbaren Element (10, 12, 14), und
- Speichern wenigstens eines Datencontainers, **dadurch gekennzeichnet, dass**
sich nicht überschneidende geschlossene Konturen die mehreren Orte in dem Gebäude in einer einzigen Ansicht auf der grafischen Karte grafisch darstellen,
ein Ort in dem Gebäude, der auf der grafischen Karte durch die entsprechende Kontur grafisch dargestellt ist, einem adressierbaren Element logisch zugewiesen wird, falls eine grafische Darstellung (33) des adressierbaren Elements innerhalb der geschlossenen Kontur enthalten ist, die den Ort auf der grafischen Karte grafisch darstellt, und
der wenigstens eine Datencontainer eine Definition eines Ortes (LOC1, LOC2) in dem Gebäude, einer geschlossenen Kontur (41), die dem Ort (LOC1, LOC2) in dem Gebäude zugehörig ist, und von adressierbaren Elementen (10, 12, 14), die dem Ort (LOC1, LOC2) in dem Gebäude zugewiesen sind, umfasst, wobei jeder Datencontainer des wenigstens einen Datencontainers ein unabhängig zugängliches und referenzierbares Datenobjekt ist, das sich auf einen einzelnen, entsprechenden Ort der mehreren Orte in dem Gebäude und Daten, die dem Ort in dem Gebäude zugehörig sind, bezieht.

15. Computerprogrammprodukt, das zum Ausführen der Schritte eines Verfahrens nach Anspruch 14 angepasst ist, wenn das Computerprogrammprodukt auf einem Computer laufengelassen wird.

## Revendications

1. Unité de traitement (100) pour commander un système électrique programmable (1) d'un bâtiment, ledit système électrique programmable (1) comprenant une pluralité d'éléments adressables (10, 12, 14), l'unité de traitement (100) comprenant :
une interface d'interaction (7) pour recevoir une entrée d'un utilisateur pour interagir avec une interface utilisateur graphique (30), ladite interface d'interaction (7) étant adaptée pour :
- rediriger une carte graphique (31) dans ladite interface utilisateur graphique (30), sur laquelle carte graphique (31) lesdits éléments adressables (10, 12, 14) sont représentés,
- représenter graphiquement une pluralité d'emplacements (LOC1, LOC2) dans ledit bâtiment par des contours correspondants (41) sur ladite carte graphique (31),
- recevoir une entrée dudit utilisateur pour ajouter, supprimer et déplacer un contour (41) représentant un emplacement (LOC1, LOC2) dans ledit bâtiment sur ladite carte graphique (31) à l'aide de ladite interface utilisateur graphique (30), et
- attribuer un emplacement (LOC1, LOC2) dans le bâtiment, représenté graphiquement sur la carte graphique par le contour correspondant, à un élément adressable (10, 12, 14),
et une mémoire de stockage (2) servant à stocker au moins un conteneur de données, **caractérisée en ce que** des contours fermés non croisés représentent graphiquement la pluralité d'emplacements dans ledit bâtiment en une seule vue sur ladite carte graphique,
un emplacement dans le bâtiment, représenté graphiquement sur la carte graphique par le contour correspondant, est attribué logiquement à un élément adressable si une représentation graphique (33) dudit élément adressable est contenue à l'intérieur du contour fermé représentant graphiquement ledit emplacement sur ladite carte graphique, et
l'au moins un conteneur de données comprend une définition d'un emplacement (LOC1, LOC2) dans le bâtiment, d'un contour fermé (41) associé audit emplacement (LOC1, LOC2) dans le bâtiment et d'éléments adressables (10, 12, 14) attribués audit emplacement (LOC1, LOC2) dans le bâtiment, chaque conteneur de données de l'au moins un conteneur de données étant un objet de données accessible et référençable indépendamment relatif à un seul emplacement correspondant de ladite pluralité d'emplacements dans le bâtiment et à des données associées audit emplacement dans le bâtiment.

2. Unité de traitement (100) selon la revendication 1, dans laquelle ladite interface d'interaction (7) est adaptée pour découper, copier et/ou enregistrer des données relatives à un emplacement et des données associées à un emplacement de ladite pluralité d'emplacements (LOC1, LOC2) dans le bâtiment représenté graphiquement sur la carte graphique (31) dans ledit au moins un conteneur de données.

3. Unité de traitement (100) selon la revendication 2, dans laquelle ladite interface d'interaction (7) est en outre adaptée pour coller et/ou charger des données relatives à un emplacement et des données associées à un emplacement (LOC1, LOC2) dans le bâtiment à représenter graphiquement sur la carte graphique (31) dudit au moins un conteneur de données.

4. Unité de traitement (100) selon l'une quelconque des revendications précédentes, dans laquelle ladite interface d'interaction (7) est adaptée pour recevoir une entrée dudit utilisateur pour configurer un modèle de comportement qui relie des éléments adressables (10, 12, 14) en actions coordonnées, dans lesquelles ledit modèle de comportement est représenté sur ladite carte graphique (31).

5. Unité de traitement (100) selon la revendication 4, dans laquelle ladite interface d'interaction (7) est adaptée pour attribuer un emplacement (LOC1, LOC2) dans le bâtiment à un modèle de comportement si ladite représentation du modèle de comportement sur la carte graphique (31) est contenue à l'intérieur du contour fermé (41) correspondant audit emplacement (LOC1, LOC2) dans le bâtiment.

6. Unité de traitement (100) selon la revendication 5, dans laquelle le conteneur de données comprend en outre une définition de modèles de comportement entre des éléments adressables (10, 12, 14) attribués audit emplacement (LOC1, LOC2) dans le bâtiment.

7. Unité de traitement (100) selon l'une quelconque des revendications précédentes, comprenant une interface de commande (8) adaptée pour faire un rendu d'une interface utilisateur de commande d'une manière sensible à l'emplacement et adaptée pour recevoir une entrée de l'utilisateur pour commander lesdits éléments adressables (10, 12, 14), les actions disponibles pour l'utilisateur dans cette interface de commande étant regroupées par ledit emplacement (LOC1, LOC2) dans le bâtiment tel qu'attribué par ladite interface d'interaction (7).

8. Unité de traitement (100) selon l'une quelconque des revendications précédentes, dans laquelle ladite interface d'interaction (7) est adaptée pour recevoir une entrée de l'utilisateur pour déplacer la représentation (33) d'un élément adressable (10, 12, 14) dans la carte graphique (31).

9. Unité de traitement (100) selon la revendication 8, dans laquelle ladite interface d'interaction (7) est adaptée pour attribuer un emplacement (LOC1, LOC2) dans le bâtiment à au moins un élément adressable (10, 12, 14) en réponse à une action de l'utilisateur pour déplacer la représentation (33) de l'au moins un élément adressable (10, 12, 14) d'une région (112) à l'extérieur d'un contour fermé (41) à une région (113) à l'intérieur du contour fermé (41) ou vice versa.

10. Unité de traitement (100) selon l'une quelconque des revendications précédentes, dans laquelle ladite interface d'interaction (7) est adaptée pour, lorsqu'un nouveau contour fermé (41) est créé, attribuer tous les éléments adressables (10, 12, 14) étant représentés dans la zone circonscrite par le contour fermé nouvellement créé (41) au nouvel emplacement (LOC1, LOC2) correspondant au contour fermé nouvellement créé (41).

11. Unité de traitement (100) selon l'une quelconque des revendications précédentes, dans laquelle ladite interface d'interaction (7) est adaptée pour recevoir une entrée de l'utilisateur pour déplacer un contour fermé (41) sur la carte graphique (31), toute représentation graphique et/ou textuelle (33) d'un élément adressable (10, 12, 14) attribué à l'emplacement qui correspond au contour fermé (41) étant déplacée le long dudit contour fermé (41).

12. Unité de traitement (100) selon l'une quelconque des revendications précédentes, dans laquelle ladite interface d'interaction (7) est adaptée pour recevoir une entrée de l'utilisateur pour redimensionner et/ou remodeler un contour fermé (41) et pour conserver lesdites représentations (33) d'éléments adressables (10, 12, 14) stationnaires sur la carte graphique (31) tout en redimensionnant et/ou en remodelant le contour fermé (41).

13. Système électrique programmable (1) comprenant une pluralité d'éléments adressables (10, 12, 14) et une unité de traitement (100) selon l'une quelconque des revendications précédentes.

14. Procédé de configuration d'un système électrique programmable (1) dans un bâtiment, ledit système électrique programmable (1) comprenant une pluralité d'éléments adressables (10, 12, 14), le procédé comprenant la fourniture d'une interface utilisateur graphique interactive (30), ladite fourniture de l'interface utilisateur graphique interactive (30) comprenant :
- le rendu d'une carte graphique (31) dans ladite interface utilisateur graphique (30), carte graphique (31) sur laquelle sont représentés lesdits éléments adressables (10, 12, 14),
- la représentation graphique une pluralité d'emplacements (LOC1, LOC2) dans ledit bâtiment par des contours correspondants (41) sur ladite carte graphique (31),
- la réception d'une entrée dudit utilisateur pour ajouter, supprimer et déplacer un contour (41) représentant un emplacement (LOC1, LOC2) dans ledit bâtiment sur ladite carte graphique (31),
- l'attribution d'un emplacement (LOC1, LOC2) dans le bâtiment, représenté graphiquement sur la carte graphique par le contour correspondant, à un élément adressable (10, 12, 14), et
- le stockage d'au moins un conteneur de données,
**caractérisé en ce que**
des contours fermés non croisés représentent graphiquement la pluralité d'emplacements dans ledit bâtiment en une seule vue sur ladite carte graphique,
un emplacement dans le bâtiment, représenté graphiquement sur la carte graphique par le contour correspondant, est attribué logiquement à un élément adressable si une représentation graphique (33) dudit élément adressable est contenue à l'intérieur du contour fermé représentant graphiquement ledit emplacement sur ladite carte graphique, et
l'au moins un conteneur de données comprend une définition d'un emplacement (LOC1, LOC2) dans le bâtiment, d'un contour fermé (41) associé à l'emplacement (LOC1, LOC2) dans le bâtiment et d'éléments adressables (10, 12, 14) attribués à cet emplacement (LOC1, LOC2) dans le bâtiment, chaque conteneur de données de l'au moins un conteneur de données étant un objet de données accessible et référençable indépendamment relatif à un seul emplacement correspondant de la pluralité d'emplacements dans le bâtiment et à des données associées audit emplacement dans le bâtiment.

15. Produit de programme informatique adapté pour exécuter les étapes d'un procédé selon la revendication 14, lorsque ledit produit de programme informatique est exploité sur un ordinateur.
